# EUROPEAN PATENT SPECIFICATION

(11) **EP 3 099 836 B1**
(45) Date of publication and mention of the grant of the patent: **20.04.2022**
(21) Application number: 14702745.2
(22) Date of filing: 14.01.2014
(51) Int. Cl.: C23C 16/455, C23C 16/40, H01M 8/1213, H01M 8/1253

(54) **A METHOD OF PRODUCING SOFC CATHODE DIFFUSION BARRIER LAYER AND A SOFC**
VERFAHREN ZUR HERSTELLUNG EINER SOFC-KATHODENDIFFUSIONSSPERRSCHICHT UND SOFC
PROCÉDÉ DE PRODUCTION DE COUCHE BARRIÈRE DE DIFFUSION DE CATHODE DE PILE À COMBUSTIBLE À OXYDE SOLIDE ET PILE À COMBUSTIBLE À OXYDE SOLIDE

(43) Date of publication of application: 07.12.2016
(73) Proprietor: Elcogen AS, 11415 Tallinn (EE)
(72) Inventor: ÖUNPUU, Enn, 13516 Tallinn (EE); SUBBI, Juhan, 12617 Tallinn (EE); SEPPÄLÄ, Sanni, 00920 Helsinki (FI); NIINISTÖ, Jaakko, 01680 Vantaa (FI); LESKELÄ., Markku, 02130 Espoo (FI); RITALA, Mikko, 02130 Espoo (FI)
(74) Representative: Kahu, Sirje
(86) International application number: PCT/EE2014/000001
(87) International publication number: WO 2015/106769

(56) References cited:
- US-A1- 2012 094 213
- NORBERT H MENZLER ET AL: "Materials and manufacturing technologies for solid oxide fuel cells", JOURNAL OF MATERIALS SCIENCE, KLUWER ACADEMIC PUBLISHERS, BO, vol. 45, no. 12, 17 February 2010 (2010-02-17), pages 3109-3135, XP019790847, ISSN: 1573-4803
- ZENG FAN ET AL: "Improving solid oxide fuel cells with yttria-doped ceria interlayers by atomic layer deposition", JOURNAL OF MATERIALS CHEMISTRY, vol. 21, no. 29, 1 January 2011 (2011-01-01), page 10903, XP055129052, ISSN: 0959-9428, DOI: 10.1039/c1jm11550b
- BIANCA MEDINA-LOTT ET AL: "Challenges Of Thin Layers For SOFC Devices: From Low-Cost Chemical Bath Deposition (CBD) to Atomic Layer Deposition (ALD)", ECS TRANSACTIONS, vol. 35, no. 1, 1 January 2011 (2011-01-01), pages 601-608, XP055129032, ISSN: 1938-5862, DOI: 10.1149/1.3570038
- Anthony S Yu ET AL: "Modification of SOFC Cathodes by Atomic Layer Deposition", Journal of The Electrochemical Society, 1 January 2013 (2013-01-01), pages 1225-1231, XP055129037, DOI: 10.1149/2.045311jes] Retrieved from the Internet: URL:http://jes.ecsdl.org/content/160/11/F1 225.full.pdf#page=1&view=FitH [retrieved on 2014-07-15]
- PAIVASAARI J ET AL: "Atomic layer deposition of rare earth oxides", TOPICS IN APPLIED PHYSICS, SPRINGER, BERLIN, DE, vol. 106, 1 January 2006 (2006-01-01), pages 15-32, XP009086073, ISSN: 0303-4216

## Description

### TECHINICAL FIELD

The invention generally relates to solid oxide fuel cells (SOFC), and more particularly to a method of manufacturing of a cathode diffusion barrier ceria layer

### BACKGROUND OF THE INVENTION

SOFC are one of the possible power sources of the future for the distributed cogeneration of electricity and heat. For this goal to materialize, the working temperature range of SOFC has to be brought down to 600 - 700 °C, from 800 - 1000 °C to facilitate the use of cheaper construction materials and diminish thermal aging of the systems. This puts special emphasis on one hand to development of solid electrolytes with lower resistivity at these temperatures, and on the other hand, development of new mixed conducting, more efficient, and selectively catalytic electrodes for oxidizing different fuels on anode and reducing oxygen on cathode of the cell. Strontium doped lanthanum cobaltite and ferrite have emerged as potential new cathode materials with higher efficiency at lower temperatures.

These more efficient cobaltite and ferrite cathode materials, however, tend to react with zirconia based electrolytes, and develop layers of high resistivity for ions, lowering SOFC efficiency and longevity. To avoid these undesirable reactions, doped ceria diffusion barrier layers are generally deposited, as ceria is chemically more inert and does not form undesirable compounds with cathode materials under the conditions, where SOFC are produced or used. Ceria, however, forms solid solutions with zirconia that have lower ion conductivity than doped zirconia or ceria. This solid solution formation is significant at temperatures 1300 °C and higher, where cell cofiring provides dense electrolyte layers.

This diffusion barrier layer has to resist diffusion of elements from cathode, preferably strontium and lanthanum, to doped zirconia electrolyte layer in course of the cathode production cycle, and in course of the element full life cycle. The diffusion barrier layer has not to be necessarily dense, but dense layer has significant advantages. The metal atom diffusion on surfaces and grain boundaries is faster than the diffusion through the grain, and so may limit the lifetime of the cell, if the diffusion barrier layer is porous. More, the dense layer will have better contact with the electrolyte for ion transfer.

The doped ceria diffusion barrier layers can been produced by
(i) Screen printing on prefired substrates, followed by sintering between 1200 °C and 1400 C, producing porous layers with thickness 0.5 - 5 micrometers with some reaction to the substrate [A. Mai et al., Solid State Ionics Vol.176 (2005) pp 1341-1350];
(ii) Pulsed laser deposition at 400 - 800 °C producing columnar structure [Jong Hoon Joo, Gyeong Man Choi, Journal of the European Ceramic Society Vol.27 (2007) pp 4273-4277][ K. Rodrigo et al., Appl Phys A Vol.101 (2010) pp 601-607];
(iii) Physical vapor deposition by magnetron sputtering at 800 °C, producing columnar structure, and providing advantages over (i) [N. Jordan et al., Solid State Ionics 179 (2008) pp 919-923].
(ii) and (iii) are conducted at lower temperature and avoid undesirable reactions with electrolyte, however, they still produce porous layers, are expensive technologies, and are hard to expand to large area production.

Atomic Layer Deposition is known art [M. Putkonen et al., Chem. Mater. Vol.13 (2001) pp 4701-4707] and used for production of ion conductor layers on porous substrates [International patent application WO02053798, Cassir M. et al, 2002]. The ALD process deposits thin layers of solid materials using two or more different vapor phase precursors. The surface of a substrate onto which film is to be deposited is exposed to a dose of vapor from one precursor. Then any excess unreacted vapor from that precursor is pumped or purged away. Next, a vapor dose of the second precursor is brought to the surface and allowed to react. A second purge completes the ALD cycle. This cycle of steps can be repeated to build up thicker films as described in Päiväsaari, J., Putkonen, M. and Niinistö, L. J. Mater. Chem. Vol.12 (2002) pp 1828-1832, Niinistö, J., Petrova, N., Putkonen, M., Sajavaara, T., Arstila, K. and Niinistö, L. J. Cryst. Growth Vol.285 (2005) pp 191-200, and Putkonen, M., Nieminen, M., Niinistö, J., Sajavaara, T. and Niinistö, L. Chem. Mater. Vol.13 (2001) pp 4701-4707.

The following solution forms the closest prior art to present invention.

A SOFC and a method to deposit a cathode diffusion barrier are disclosed in US 2012/094213A1 "Solid oxide electrolyte membrane, method of manufacturing the same and fuel cel including the solid oxide electrolyte membrane", Ha Jin-Su et al, 2012. However, Ha refers to depositing of the insulating layer to close pinholes in electrolyte and reduce electronic leakage current, and not to the chemical diffusion barrier layer to resist high temperature cation diffusion under cathode manufacturing and working conditions.

A method for manufacturing a SOFC wherein sintering of the electrolyte and the cathode are done separately, in order to reduce interaction with the electrolyte is disclosed by N.H. Menzler et al. "Materials and manufacturing technologies for solid oxide fuel cells", Journal of Materials Science, Kluwer Academic Publishers, BO, Vol 45, No 12, 17.02.2012, pages 3109 - 3135. In this paper a doped ceria layer to prevent interaction between zirconia and LSFC cathodes is described. The difficulties with regard to using ALD technology are also mentioned: ALD is not line-of-sight process, and can also coat inner surfaces of open pores.

Production of yttria-doped ceria interlayers by ALD method is described by Zeng Fan et al "Improving solid oxide fuel cells with yttria-doped ceria interlayers by atomic layer deposition," Journal of Materials Chemistry, The Royal Society of Chemistry, Vol. 21, pp. 10903-10906, 2011. The publication refers to depositing ceria layer to improve oxygen incorporation from platinum electrode and enhance electrochemical performance, and is silent whether the cited interlayer would work as a chemical diffusion barrier layer.

To overcome these problems in the art, an inexpensive method, namely Atomic Layer Deposition (ALD), of producing dense cathode diffusion barrier ceria layer, appropriate for large area production, and a solid oxide fuel cell with increased efficiency and longevity is described in this invention.

### DISCLOSURE OF THE INVENTION

The object of this invention is to provide an improved method for producing cathode diffusion barrier ceria layer, and with that to provide a solid oxide fuel cell that has higher efficiency and longevity than known from the state of art.

It comprises depositing a pure ceria or aliovalently doped ceria layer, by atomic layer deposition, on the electrolyte layer of the sintered half cell. The surface of a electrolyte onto which film is to be deposited is exposed to a dose of vapor from one or more lanthanide first precursors. Then any excess unreacted vapor from that precursor is removed (pumped or purged away). Next, a vapor dose of the second precursor is brought to the surface and allowed to react. A second purge completes the ALD cycle. This cycle of steps is repeated to build up thicker films. Different lanthanides in consecutive cycles will be used to build mixed oxides. This ceria layer forms a cathode diffusion barrier layer on top of which a cobaltite based cathode layer is applied by screenprinting, and the cathode diffusion barrier layer and cathode layer are heated together to form a improved solid oxide fuel cell. The heating temperature is between 1000-1200 °C, preferably between 1000 and 1100 °C.

The first precursors are lanthanide diketonates with general formula Ln(thd)_{n,} where thd is 2,2,6,6-tetramethylheptane-3,5-dionate, or any other volatile lanthanide compound that is thermally stable enough for meeting the requirement of self-limiting growth, and n is 3 or 4. The pulsing ratio for deposition of first precursors Ce(thd)4 and Y(thd)3 or Gd(thd)3 is from 30:1 to 5:1, preferably 10:1. The second precursor is ozone or water. The electrolyte layer is yttrium stabilized zirconia or scandium stabilized zirconia, and ceria layer is preferably Y or Gd doped ceria layer.

The cobaltite based cathode layer is preferably LSC (LaₓSr₍₁₋ₓ₎CoO₃) or LSCF (LaₓSr₍₁₋ₓ₎Co_{y}Fe_{(1-y)}O₃) layer.

### BRIEF DESCRIPTION OF DRAWINGS

Figure 1. Fuel cell scheme. 1 - cathode, 2 - cathode diffusion barrier layer, 3 - electrolyte, 4 - anode active layer, 5 - anode support layer.
Figure 2. Fuel cell. 1 - cathode, 2 - cathode diffusion barrier layer, 3 - electrolyte, 4 - anode active layer, 5 - anode support layer.
Figure 3. Fuel cell in more detail. 1 - cathode, 2 - cathode diffusion barrier layer, 3 - electrolyte.
Figure 4. Growth rates of a) CeO₂ b) Gd₂O₃ and c) Y₂O₃ with different metal precursor pulse lengths of 0,5-2,0 s. The deposition temperature was 250 °C.

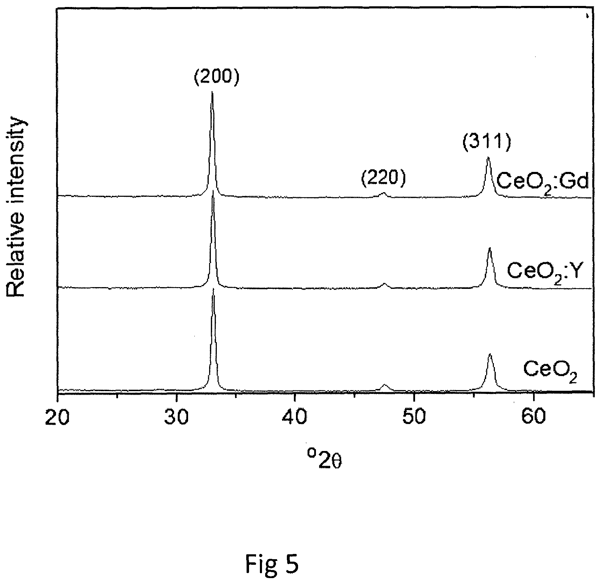

Figure 5. XRD patterns of 200 nm thick CeO₂, CeO₂:Gd and CeO₂:Y films on Si(100).

### DETAILED DESCRIPTION OF THE PREFERRED EMBODIMENTS

The fuel cell is produced by depositing a aliovalently doped ceria layer 2, preferably Y or Gd doped ceria layer 2, by ALD, on the yttrium stabilized zirconia electrolyte 3 layer of the sintered half cell, on top of that is screen printed a cobaltite based cathode 1 layer, preferably lanthanum strontium cobaltite (LaₓSr₍₁₋ₓ₎CoO₃) (LSC) or lanthanum strontium cobaltite ferrite

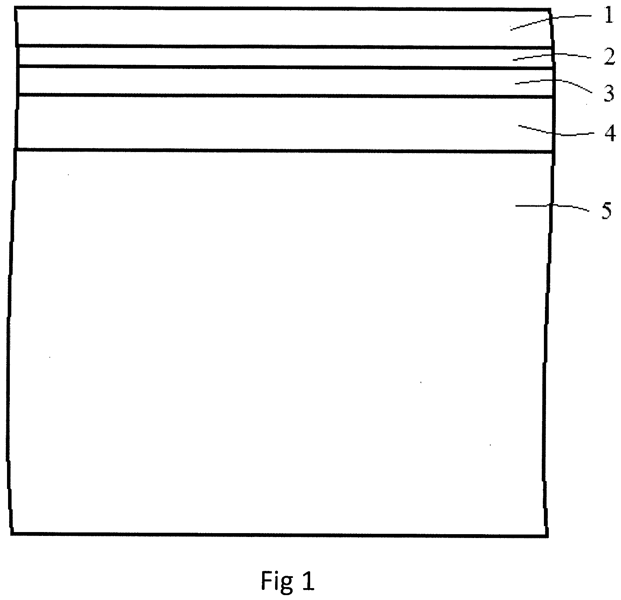

(LaₓSr₍₁₋ₓ₎Co_{y}Fe_{(1-y)}O₃) (LSCF) layer, and the so covered cell is heated between 1000 °C and 1200 °C, preferably between 1000 °C and 1100 °C. The scheme of the cell is on Figure 1.

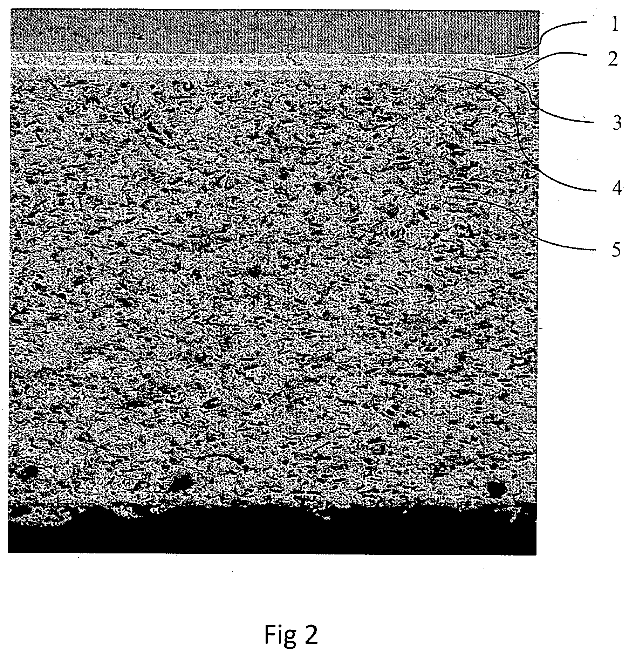

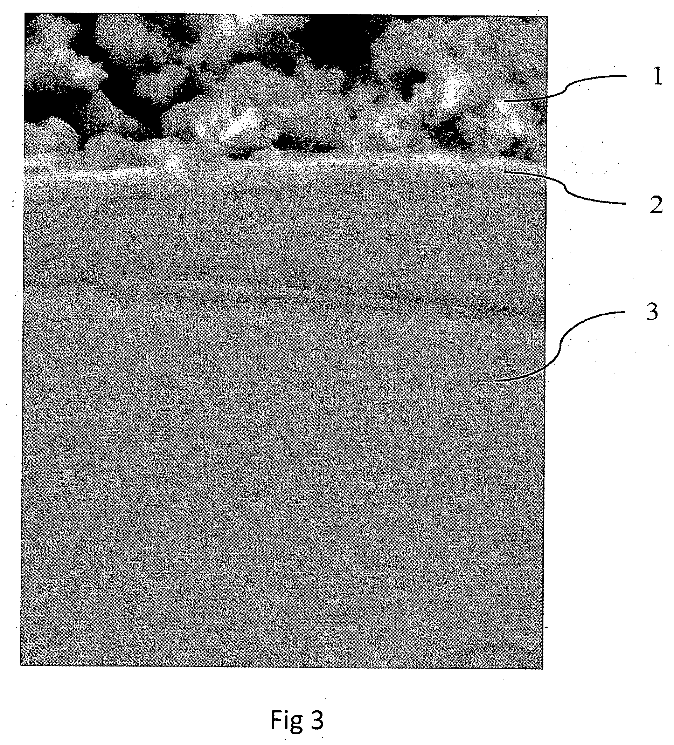

The heating of the raw ALD ceria layer 2 together with the cathode 1 layer produces advantageous contact between cathode diffusion barrier ceria layer 2 and electrolyte 3 layer, and cathode diffusion barrier ceria layer 2 and cathode 1 layer. This provides almost continuous cathode diffusion barrier ceria layer 2 with lower electrical resistivity and better diffusion resistance than state of art. SEM cross-sections of the cell are on Figures 2 and 3.

The ALD cathode diffusion barrier ceria layer 2 has multiple advantages over state of art. Compared to screen printed layer it is denser, forming better barrier for cation diffusion. It is produced at lower temperature minimizing interdiffusion of barrier layer material and electrolyte material, lowering electrical resistance of the fuel cell. It also excludes one heating round from the production cycle, increasing the productivity and lowering cost.

Compared to physical vapor deposition (sputtering), ALD cathode diffusion barrier ceria layer 2 is denser, much more conformal, avoids columnar structure, and with that forms a better barrier for cation diffusion. ALD method has also advantages over sputtering for industrial scaling up, as the fuel cells can be packed close together in the reactor chamber.

### EXAMPLES

### 1. CeO₂, CeO₂:Gd and CeO₂:Y cathode diffusion diffusion barrier ceria layers for solid oxide fuel cells by atomic layer deposition

Diffusion barrier ceria layers 2 CeO₂, CeO₂:Gd and CeO₂:Y were deposited by atomic layer deposition (ALD) on solid oxide fuel cell (SOFC) button cells to prevent the diffusion of cations from the cathode 1 to the electrolyte 3. First, the growth rates of binary oxides CeO₂, Gd₂O₃ and Y₂O₃ were determined on Si(100) wafers and yttria stabilized zirconia (YSZ). Doped films were then deposited on Si(100) with different Ce:Gd and Ce:Y precursor pulse ratios to find the right ratio for the dopant content. The actual films were deposited on SOFC half cells that consisted of NiO/YSZ anode 4 and YSZ electrolyte 3.

All films were deposited in a flow-type hot-wall ALD reactor (ASM Microchemistry F-120). Pressure in the reactor was 5-10 mbar. Ce(thd)4, Gd(thd)3 and Y(thd)3 (thd= 2,2,6,6-tetramethyl-3,5-heptanedione) (VolatecOy) were used as metal precursors and ozone (100 g/m3) produced from oxygen (AGA, 99,999 %) with ozone generator (Wedeco OZOMATIC 4 HC) was used as an oxygen source. Nitrogen (Domnick Hunter N2 generator, >99,999 %) was used as carrier and purging gas.

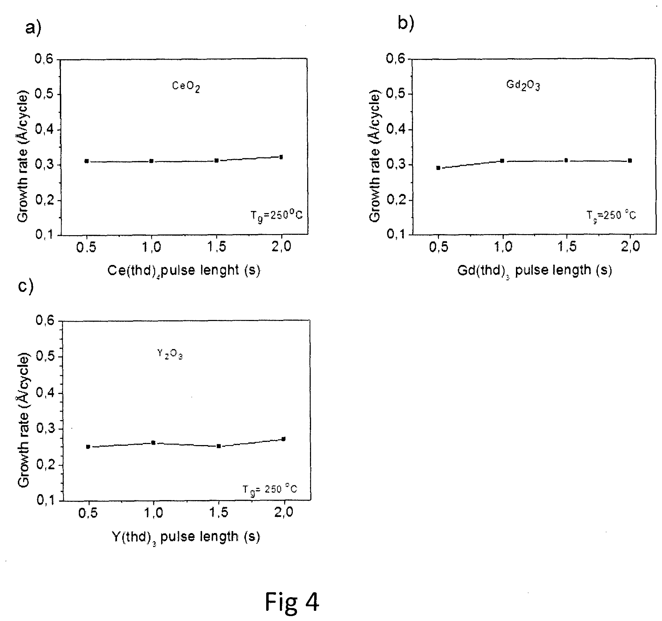

Film thicknesses were determined from reflectance spectra. The spectra were measured at wavelengths between 370 and 1100 nm in Hitachi U-2000 spectrophotometer. The thickness of CeO₂ on YSZ was determined from k values of the elements measured with energy dispersive X-ray analysis (EDX). The dopant levels of the doped films were also determined by EDX. Crystallinity of the deposited films was determined by X-ray diffraction (XRD) with Cu Ká radiation in PanalyticalX′Pert PRO MPD diffractometer. The binary oxides CeO₂, Gd₂O₃ and Y₂O₃ deposited by ALD have been thoroughly studied before. Reported growth rates are 0,32 Å/cycle for CeO₂, 0,30 Å/cycle for Gd₂O₃ and 0,22-0,23 Å/cycle for Y₂O₃ at 250 °C. In this work the growth rates were 0,31 Å/cycle for CeO₂, 0,30 Å/cycle for Gd₂O₃ and 0,25 Å/cycle for Y₂O₃ at 250 °C. The growth rate of CeO₂ on YSZ was only slightly lower than on Si(100). In all cases, ALD type self-limiting growth mode was confirmed (Figure 4).

Doped films were deposited on Si and the right Gd:Ce and Y:Ce precursor pulsing ratios in order to obtain 10 cation-% dopant level were determined. The studied pulsing ratios and dopant contents measured by EDX are presented in Tables 1 and 2.

**Table 1. Gadolinium content of CeO₂:Gd films deposited with different pulsing ratios.**

| Gd:Ce pulse ratio | Gd (cation-%) |
|---|---|
| 1:2 | 38 |
| 1:10 | 12 |
| 1:20 | 8 |

**Table 2. Yttrium content of CeO₂:Y films deposited with different pulsing ratios.**

| Y:Ce pulse ratio | Y (cation-%) |
|---|---|
| 1:1 | 57 |
| 1:2 | 41 |
| 1:10 | 10 |

### 2. Cell manufacturing

First a half-cell is manufactured. The half-cell is manufactured by tape casting the anode support layer 5 composed of YSZ and NiO (5), screen printing on top of this anode active layer composed of YSZ and NiO (4), screen printing on top of this electrolyte 3 layer composed of YSZ (3), and sintering this multilayer green half-cell at 1400 °C. The complete fuel cell is produced by depositing a pure ceria or aliovalently doped ceria layer 2, preferably Y or Gd doped ceria layer 2, by ALD, on the yttrium stabilized zirconia electrolyte 3 layer of the sintered half cell, on top of that is screen printed a cobaltite based cathode 1 layer, preferably LSC or LSCF layer, and the so covered cell is heated between 1000 °C and 1200 °C, preferably between 1000 °C and 1100 °C, so that temperature stays over 1000 °C for at least one hour.

Based on the above ALD results, pulsing ratio of 1:10 was chosen for the deposition of CeO₂:Gd and CeO₂:Y films on SOFC button cells. The deposition temperature was 250 °C. Ce(thd)4 was kept at 170 °C, Gd(thd)3 at 137 °C, and Y(thd)3 at 127 °C. Pulse lengths were 0,5 s for Gd(thd)3 and Ce(thd)4, and 1,0 s for Y(thd)3. Purge was 1,0 s after Gd(thd)3 and Ce(thd)4 pulses, and 1,5 s after Y(thd)3 pulses. Ozone pulse was always 1,0 s and purge after ozone 1,5 s. In order to deposit 100 nm thick CeO₂ films, 3334 cycles were applied. For 200 nm thick films 7800 cycles were applied. For doped films, 10 cycles of CeO₂ was deposited first and then one cycle of Gd₂O₃ or Y₂O₃. For 100 nm thick films this sequence was repeated 337 times and for 200 nm thick films 674 times. The XRD patterns of 200 nm thick CeO₂, CeO₂:Gd and CeO₂:Y films on Si(100) are shown in Figure 2. The phase is cubic CeO₂ (PDF card 34-0394) and the most intensive reflection is (200).

## Claims

1. A method of producing SOFC cathode (1) diffusion barrier layer (2) comprising the subsequent steps of:
a) depositing a pure ceria or aliovalently doped ceria layer (2), by atomic layer deposition, on the electrolyte (3) layer composed of aliovalently stabilized zirconia, of the sintered half cell, whereas the surface of a electrolyte (3) onto which film is to be deposited is exposed to a dose of vapor from one or more lanthanide first precursors with general formula Ln(thd)ₙ, whereby thd is 2,2,6,6-tetramethylheptane-3,5-dionate, and n is 3 or 4, the second precursor is ozone or water and any excess unreacted vapor from that precursor is removed, and a vapor dose of the second precursor is brought to the surface and allowed to react, and this cycle of steps is repeated to build up thicker films;
b) screenprinting on top of said ceria layer (2) cobaltite based cathode (1) layer, wherein said cobaltite cathode layer is lanthanum strontium cobaltite (LSC) or lanthanum strontium cobaltite ferrite (LSCF) layer.
c) heating the cathode diffusion barrier ceria layer (2) and cathode (1) layer together, wherein the heating temperature is between 1000 and1100° C for at least one hour.

2. The method of claim 1, **characterized in that** the electrolyte (3) layer is yttrium stabilized zirconia.

3. The method of claim 1, **characterized in that** the electrolyte (3) layer is scandium stabilized zirconia.

4. The method of claim 1, **characterized in that** said ceria layer (2) is preferably Y or Gd doped ceria layer.

5. The method of claim 1, **characterized in that** the pulsing ratio for deposition of first precursors Ce(thd)₄ and Y(thd)₃ or Gd(thd)₃ is from 30:1 to 5:1.

6. The method of claim 1, **characterized in that** different lanthanides in consecutive cycles of step a) are used to build mixed oxides.

## Patentansprüche

1. Verfahren zur Herstellung einer SOFC-Kathoden-(1)-Diffusionsbarriereschicht (2), umfassend die nachfolgenden Schritte:
a) Abscheidung einer reinen Ceroxid- oder aliovalent dotierten Ceroxidschicht (2) durch Atomlagenabscheidung auf der aus aliovalent stabilisiertem Zirkoniumdioxid bestehenden Elektrolytschicht (3) der gesinterten Halbzelle, wobei die Oberfläche des Elektrolyten (3), auf der der Film abgeschieden werden soll, einer Dosis von Dampf aus einem oder mehreren ersten Lanthanidvortäufern mit der allgemeinen Formel Ln(thd)ₙ ausgesetzt wird, wobei thd 2,2,6,6-Tetramethylheptan-3,5-dionat ist und n 3 oder 4 ist, der zweite Vorläufer Ozon oder Wasser ist und jeglicher überschüssiger, nicht umgesetzter Dampf von diesem Vorläufer entfernt wird, und eine Dampfdosis des zweiten Vorläufers auf die Oberfläche gebracht und reagieren gelassen wird, und dieser Zyklus von Schritten wiederholt wird, um dickere Filme zu bilden;
b) Siebdrucken einer Kathodenschicht (1) auf Kobaltitbasis auf die Ceroxidschicht (2), wobei die Kobaltitkathodenschicht eine Lanthanstrontiumkobaltit- (LSC) oder Lanthanstrontiumkobaltitferrit-(LSCF) Schicht ist.
c) Erhitzen der Kathoden-Diffusionsbarrieren-Ceroxidschicht (2) und der Kathodenschicht (1) zusammen, wobei die Erhitzungstemperatur für mindestens eine Stunde zwischen 1000 und 1100 °C liegt.

2. Verfahren nach Anspruch 1, **dadurch gekennzeichnet, dass** die Elektrolytschicht (3) Yttriumstabilisiertes Zirkoniumoxid ist.

3. Verfahren nach Anspruch 1, **dadurch gekennzeichnet, dass** die Elektrolytschicht (3) scandiumstabilisiertes Zirkoniumoxid ist.

4. Verfahren nach Anspruch 1, **dadurch gekennzeichnet, dass** die Ceroxidschicht (2) vorzugsweise eine Y- oder Gd-dotierte Ceroxidschicht ist.

5. Verfahren nach Anspruch 1, **dadurch gekennzeichnet, dass** das Pulsverhältnis zum Abscheiden der ersten Vorläufer Ce(thd)₄ und Y(thd)₃ oder Gd(thd)₃ 30:1 bis 5:1 beträgt.

6. Verfahren nach Anspruch 1, **dadurch gekennzeichnet, dass** unterschiedliche Lanthanide in aufeinanderfolgenden Zyklen von Schritt a) verwendet werden, um Mischoxide aufzubauen.

## Revendications

1. Le procédé de production d'une couche barrière de diffusion (2) de cathode SOFC (1) comprenant les étapes suivantes consistant à :
a) déposer d'une couche de cérine pure ou d'une couche de cérine dopée aliovalentement (2) par dépôt d'une couche atomique, sur la couche d'électrolyte (3) constituée de zircone stabilisée aliovalentement, de la demi-cellule frittée, dans lequel la surface de l'électrolyte (3), sur laquelle le film doit être déposé, est exposé à une dose de vapeur d'un ou plusieurs des premiers précurseurs de lanthanide de formule générale Ln(thd)ₙ, dans laquelle thd est le 2,2,6,6-tétraméthylheptane-3,5-dionate, et n est 3 ou 4, le deuxième précurseur est de l'ozone ou de l'eau, et tout excès de vapeur n'ayant pas réagi de ce précurseur est éliminé, et une dose de vapeur du deuxième précurseur est portée à la surface, et l'on laisse la réaction de se trouver lieu, et ce cycle d'étapes est répété afin d'accumuler les films plus épais ;
b) sérigraphier, au-dessus de ladite couche de cérium (2), une couche de cathode (1) à base de cobaltite, dans laquelle ladite couche de cathode de cobaltite est une couche de cobaltite de lanthane strontium (LSC) ou de ferrite de cobaltite de lanthane strontium (LSCF).
c) chauffer la couche de cérium barrière de diffusion cathodique (2) et la couche cathodique (1) ensemble, la température de chauffage étant comprise entre 1000 et 1100 °C, pendant au moins une heure.

2. Le procédé selon la revendication 1, **caractérisé en ce que** la couche d'électrolyte (3) est de la zircone stabilisée à l'yttrium,

3. Le procédé selon la revendication 1, **caractérisé en ce que** la couche d'électrolyte (3) est de la zircone stabilisée au scandium.

4. Le procédé selon la revendication 1, **caractérisé en ce que** ladite couche de cérine (2) est de préférence une couche de cérine dopée de Y ou de Gd.

5. Le procédé selon la revendication 1, **caractérisé en ce que** le rapport d'impulsions pour le dépôt des premiers précurseurs Ce(thd)₄ et Y(thd)₃ est de 30:1 à 5:1.

6. Le procédé selon la revendication 1, **caractérisé en ce que** les lanthanides différents dans les cycles consécutifs de l'étape a) sont utilisés pour construire des oxydes mixtes.
